# EUROPEAN PATENT SPECIFICATION

(11) **EP 0 938 247 B1**
(45) Date of publication and mention of the grant of the patent: **26.02.2003**
(21) Application number: 98310097.5
(22) Date of filing: 09.12.1998
(51) Int. Cl.: H04R 1/08, H01R 13/24, H04M 1/03

(54) **Holder equipped with an anisotropically conductive rubber connector and method for manufacturing the same**
Haltevorrichtung mit einem Verbindungselement aus anisotropisch leitendem Gummi und Herstellungsverfahren
Support équippé avec un connecteur en caoutchouc à conductance anisotropique et méthode de fabrication

(30) Priority: 26.12.1997 JP 36661997
(43) Date of publication of application: 25.08.1999
(73) Proprietor: Polymatech Co., Ltd., Tokyo (JP)
(72) Inventor: Konno, Hideaki, Polymatech Co., Ltd. R&D Ctr.10-5, Tokyo (JP)
(74) Representative: Whalley, Kevin

(56) References cited:
- EP-A- 0 880 299
- EP-A- 0 888 031
- WO-A-95/05715
- WO-A-95/27323
- US-A- 4 209 481

## Description

The present invention relates to a holder and a manufacturing method thereof for holding on a substrate a small type microphone, a loudspeaker, etc. (built-in electronic parts) such as a portable cellular telephone, personal handy phone system, personal digital assistant (PDA), or the like and electrically connecting them.

Electrodes of electronic parts of microphones, loudspeakers, etc. used for portable communication equipment etc. are generally soldered to substrate electrodes by using lead wires. Since these connections have to be soldered via fine lead wires by means of manual work, this results in low productivity and increased costs. Moreover, due to the lead wires, a larger space is required and this cannot correspond to requirements for miniaturization in recent years.

On the other hand, using a conductive elastic connector allows a method of electrical interconnection between the electrodes.

However, since the conductive elastic connector has a laminated structure of an insulating elastic part and a conductive elastic part and is manufactured by a special method, a manufacturing process different from that of a holder for mounting conventional electronic parts has to be adopted. Fine working is needed for positioning the electrodes of the electronic parts to those of the elastic connectors or the need arises for bonding the holder and the connector part to each other, which still does not permit satisfactory productivity.

Attention is also drawn to the disclosure of US-A-4209481, which relates to an elastic connector having an anisotropic conductivity and a process for its production. According to this document electroconductive magnetic wires are dispersed and arranged in an elastomeric sheet. A magnetic field orients said wires in a direction perpendicular to the plane of the sheet. Such a sheet can be inserted between the circuit elements and held in place by light pressure thereby making electrical contact between the terminals.

It is an object of the present invention to solve the problems of the prior art and to provide a holder and a manufacturing method thereof intended for simplifying an attaching process, decreasing manufacturing cost, and reducing mount space.

The present invention in one aspect provides a holder for a built-in electronic part, comprising a holding part having an elastic body for holding the built-in electronic part and an elastic connector part comprising a conductive pattern of magnetic electrically conductive parts, characterized in that the holding part and the elastic connector part are integrally molded into one piece.

The invention in another aspect provides a method for manufacturing a holder according to the one aspect of the invention, comprising the steps of: pouring a liquid polymer mixed with a magnetic electric conductor into a metallic mold for forming a holder; applying a magnetic field to a desired position in the metallic mold; identifying the connector part by orienting the magnetic electric conductor by the magnetic field; and then, integrally molding the holding part and the elastic connector part into one piece by crosslinking the liquid polymer.

The present invention thus provides a holder and a manufacturing method thereof, wherein electrodes of built-in electronic parts such as a small type microphone, a loudspeaker, or the like and those of a substrate are connected with each other by using a conductive elastic connector, and a holding part for holding the built-in electronic part and the elastic connector part are integrated into one piece for easily mounting the built-in electronic parts.

The invention will be further described with reference to the accompanying drawings, in which:
Fig. 1 is an exploded perspective view showing a holder in accordance with the present invention;
Fig. 2 is a cross-sectional view of a metallic mold;
Fig. 3 are top views and cross-sectional views of conductive patterns of the holder;
FIG.4 is a plan view and a cross-sectional view of the holder;
FIG.5 is a cross-sectional view showing a molded state;
FIG.6 is an assembly drawing showing a method of assembling a holder on a substrate; and
FIG.7 is an assembly drawing showing another method of assembling a holder on a substrate.

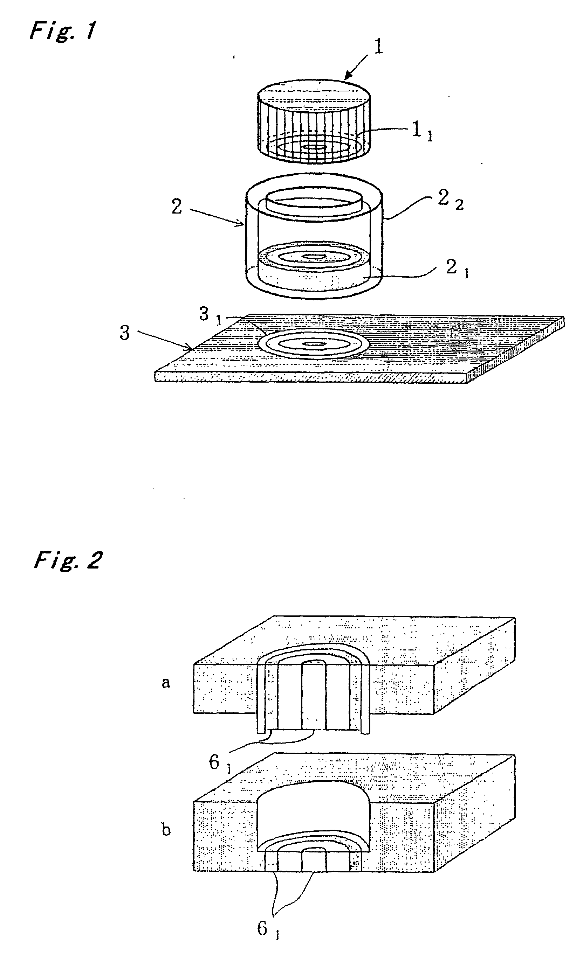

FIG.1 shows an exploded view of the holder in accordance with the present invention.

A conductive elastic connector part 2₁ comprising rubber, etc. is used for an electric connection between electrodes 1₁ of a built-in electronic part 1 such as a small type microphone or loudspeaker, or the like and electrodes 3₁ of a substrate 3, and a holding part 2₂ of the holder is integrated into one piece with an elastic connector part 2₁ so that the built-in electronic part 1 can easily be assembled.

The built-in electronic part 1 is pushed into the holder 2 for being engaged with a holding part 2₂, and the electrodes 1₁ on a bottom face of the built-in electronic part and the electrodes 3₁ of the substrate 3 are brought into conduction via the conductive elastic connector part 2₁.

For a conductive part of the conductive elastic connector 2₁, a low resistance one is used considering the electric capacity of the built-in electronic part. A contact resistance of 10Ω or less is preferred, and for the medium of the conductive part, low resistance metal powder, metal-plated carbon, graphite, etc., metal wire, etc. are desirable. A conductive pattern is formed on the conductive part in advance so that the electrodes 1₁ of the built-in electronic part 1 are connected with the corresponding electrodes of the substrate 3₁ respectively.

FIG.2 shows the method for manufacturing the holder in accordance with the present invention.

A metallic mold is used in which a magnetic body 6₁ of iron or nickel alloy, etc. is buried in the same pattern as a desired conductive pattern. The magnetic body 6₁ in a punch (a) is projectingly formed so as to enter into a die (b), and the magnetic body 6₁ is also buried in the bottom of the die (b).

This metallic mold is provided with a magnetic conductor chain formed by pouring into the die (b) a material which is liquid polymer such as silicone, urethane, etc. mixed with a magnetic conductor such as nickel, iron, cobalt, etc. or an alloy of these as main components, or a conductor such as copper, aluminium, gold, silver, etc. plated with said magnetic conductive metals, or on the contrary the magnetic conductive metal plated with the conductor, and vertically applying a magnetic field thereto and linking together the magnetic conductors in the material in the direction of the magnetic lines of force. Namely, since a magnetic conductive chain is oriented vertically to the elastic connector part 2₁ in the figure, the elastic connector part 2₁ is formed which has anisotropy bringing it into conduction only vertically. Then, the liquid polymer such as silicone, urethane, etc. in the metallic mold is cured by heat treatment, etc. and the holding part and the elastic connector part are integrated for completing the holder 2. Thus, the production is simplified and the built-in electronic part only may be fitted in the holder at the time of use, and consequently the need for fine working such as alignment of the electrodes is eliminated.

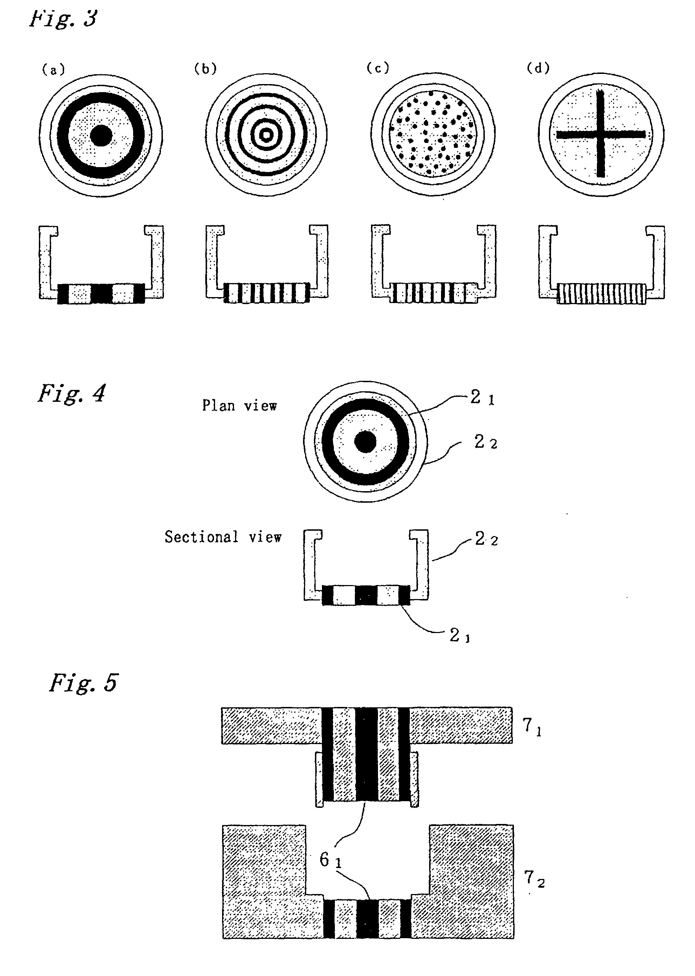

FIG.3 shows top views and cross-sectional views of conductive patterns of the holder.

In the conductive part of the holder, the conductive pattern is formed so that the electrodes of the built-in electronic part can be connected with the corresponding electrodes of the substrate respectively. Foe example, as shown in FIG.3, a type (a) of the same pattern as that of the electrodes 1₁ of the electronic part 1, a type (b) of a concentric conductive part, a type (c) of a random conductive part, a type (d) of cross-shaped conductive part, etc. are considered. Moreover, when the type (d) is oriented by a magnetic force, there is no leakage between the positive and negative electrodes.

In FIG.4, the conductive elastic connector part 2₁ has a shape vertically projected to the bottom of the holder 2₂ for allowing the electrodes 1₁ of the built-in electronic parts 1 to contact with the electrodes 3₁ of the substrate satisfactorily, and is further designed to be appropriately compressed.

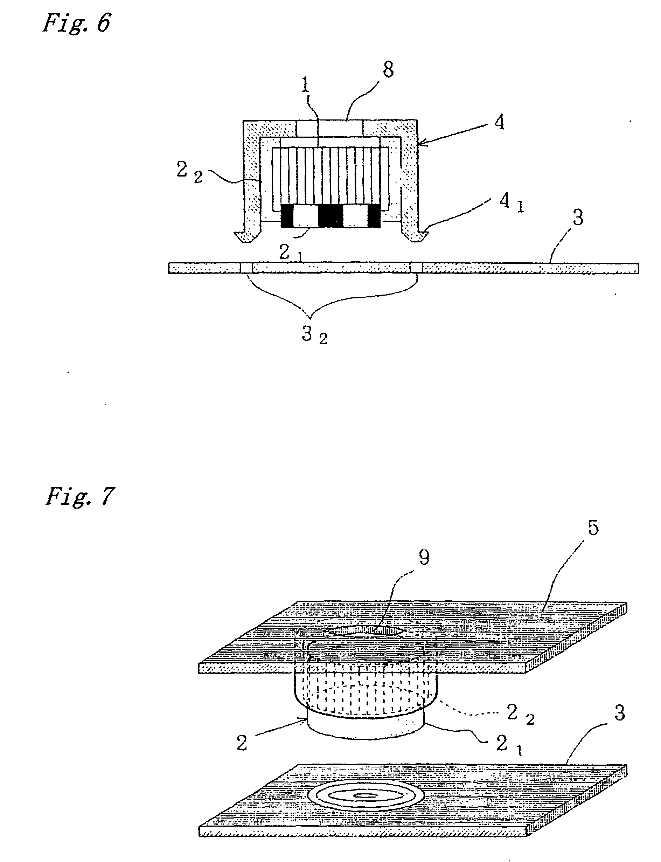

The holder shown in FIG.4 is formed by using a metallic mold 7 shown in FIG.5. This metallic mold is not specifically restricted as to the material unless it has magnetism, and materials such as aluminium, various alloys, or resin, etc. can be used. In this metallic mold, the magnetic materials 6₁ of the same pattern as the conductive part are buried at desired positions in the punch and die of the mold. The material buried in the metallic mold is not specifically restricted if it has magnetism, and alloys of iron, nickel, cobalt, chrome, etc. may be used.

A manufacturing method for products of the embodiment 1 will be described.

A material, which is a mixture of 100 pts. wt. of liquid silicone rubber (Wacker Chemical Co., Ltd. LR7665A/B) and 5-50 pts. wt. of nickel powder is well mixed and defoamed, poured into the die 7₁ of the metallic mold 7, and a magnetic field (a magnetic density = 499 gauss) is applied the material from beneath to-above the die 7₁ so as to orient the nickel powder to the conductive pattern. Then, a punch 7₂ is applied thereon and said liquid silicone rubber is cured by applying heat at 120 °C for obtaining the holder shown in FIG.4. In order to prevent the nickel powder from entering in the holding part 2₂, a magnetic field was applied to the die 7₁ in which the material had been poured and the nickel powder was oriented to the pattern of the conductive part.

If the amount of nickel powder to be added is less than 5 pts. wt., there is a danger that a part is formed wherein nickel particle chains may not pass through the conductive elastic connector part 2₁ in the vertical direction. If the nickel powder amount exceeds 50 pts. wt., there is a danger that the central circular part of the conductive elastic connector part 2₁ and the circumferential part may be subject to electrical conduction and leakage. Therefore, an amount of 5-50 pts. wt. of nickel powder to 100 pts wt. of liquid silicone rubber is desirable, more preferably 10-20 pts. wt.

Table 1 shows a relationship between particle diameter. of the magnetic conductive powder and resistance value of the conductive elastic connector part.

Resistance values of the conductive elastic connector part 2₁ of the obtained holder 2 are dependent on the particle diameter of the nickel powder, and the larger the particle diameter of the nickel powder, the lower and the more stable the resistance value obtained. When a holder 2 having a low and stable resistance value only is desired, for example, nickel powder of 125 µm or larger particle diameter can be used. However, the larger the particle diameter of the nickel powder, the greater the tendency that the dispersibility becomes worse, and therefore the smaller the particle diameter, the better the conductive pattern formed. Consequently, when it is desired to form a better conductive pattern and obtain a stable and low resistance, for example, it is desirable to use gold- or silver-coated nickel powder of 30 µm to 40 µm particle diameter.

Table 2 shows orientation time depending on viscosity of liquid polymer and particle diameter of nickel powder. The viscosity of the liquid polymer influences the orientation time of the nickel powder. Basically, the lower the viscosity, the shorter the orientation time, and this is advantageous for the forming cycle. However, since there is a tendency that the lower the viscosity of the polymer, the worse the physical properties become after being cured, and a desirable polymer viscosity is 10P to 2500P, more preferably 100P to 1000P (1P=0,1 Pa.s).

An example of a method for assembling the holder 2 in accordance with the present invention is described in the following.

When a conductive elastic connector is used, the elastic connector part needs to be compressed to some extent in the assembling method to obtain a stable conduction. Although a compression rate is generally set depending on the thickness of the elastic connector part, 8-20% is a suitable range.

In an assembling method shown in FIG.6, the elastic connector part 2 is comprised of a material, for example, resin, having a compressible hardness; an attaching bracket 4 provided with a hole 8 at a desired position is provided separately; and the holder 2 having been engaged with the built-in electronic part 1 is attached to the bracket 4. Attaching parts 4₁ of the attaching bracket 4 are inserted into attaching holes 3₂ in the substrate 3 for fixing. At the same time, the elastic connector part 2₁ is compressed by the attaching bracket 4 and the substrate 3 and exhibits a stable resistance.

FIG. 7 shows another assembling method, whereby a microphone holder 2 is assembled, which is an integrated element of the elastic connector part 2₁ and the holding part 2₂ having assembled the built-in electronic part 1 in a case 5 provided with a hole 9 at a desirable position. When the case 5 is assembled on a main body, the elastic connector 2₁ is pressed between the case 5 and the substrate 3 and is brought into a stable connection. Consequently, since only a part assembly process will be performed without a soldering process for connecting lead wires, etc., simple assembly becomes possible.

The holder in accordance with the present invention is an integrated element of the elastic connector part and the holding part used for attaching electronic parts of a microphone is used on portable telephone equipment, etc to the substrate. Moreover, since the soldering process for connecting lead wires, etc. can be eliminated, the number of parts and the manufacturing costs can be reduced.

Further, according to the manufacturing method of the present invention, it is possible to easily manufacture the holder which is an integrated element of a complex shape of the holding part and the elastic connector part.

**Table 1**

| Relationship between particle diameter of magnetic conductive powder and resistance (20 pts . wt. nickel added to 100 pts. wt. polymer) | | | | | |
|---|---|---|---|---|---|
| magnetic conductive powder | particle diameter | compression rate of rubber connector (thick 1.8mm) | | | |
| | | 6% | 11% | 17% | 22% |
| globular nickel powder | 125 µm | 0.7Ω | 0.5Ω | 0.3Ω | 0.3Ω |
| " | 75 µm | 1.0kΩ | 13.2Ω | 3.6Ω | 1.1Ω |
| " | 50µm | 1.2kΩ | 39Ω | 7.5Ω | 5.0Ω |
| " | 30µm | 1.3kΩ | 230Ω | 90Ω | 23Ω |
| " | 3µm | 3.1kΩ | 570Ω | 520Ω | 200Ω |
| globular silver-coated nickel powder | 30µm | 11Ω | 0.4Ω | 0.3Ω | 0.2Ω |

**Table 2**

| Orientation time dependent on viscosity and particle diameter of nickel | | | | |
|---|---|---|---|---|
| base viscosity | nickel particle diameter | orientation time(s) | base viscosity | orientation time(s) |
| 10mP | 125 µm | 0 | 1000P | 15 |
| | 75µm | 0 | | 30 |
| | 50µm | 0 | | 60 |
| | 30µm | 0 | | 120 |
| | 3µm | 0 | | > 600 (> 600) |
| 10P | 125µm | 0 | 2500P | 120 |
| | 75µm | 0 | | 300 (90) |
| | 50µm | 0 | | > 600(110) |
| | 30µm | 1 | | > 600 (120) |
| | 3µm | 15 | | >600(> 600) |
| 100P | 125µm | 2 | 7000P | > 600 (> 600) |
| | 75µm | 2 | | > 600 (> 600) |
| | 50µm | 3 | | > 600 (> 600) |
| | 30µm | 15 | | > 600 (> 600) |
| | 3µm | 180 | | > 600 (> 600) |
| 200P | 125µm | 5 | | |
| | 75µm | 10 | | |
| | 50µm | 20 | | |
| | 30µm | 30 | | |
| | 3µm | >600 ( >600) | | |
| Orientation(forming) time of a conductive part pattern when the following sample is put in a die of a mold and a magnetic force (400G) is applied Values in ( ) show orientation(forming) times when a magnetic force (3000G) is applied | | | | |

## Claims

1. A holder (2) for a built-in electronic part (1), comprising a holding part (2₂) having an elastic body for holding the built-in electronic part (1) and an elastic connector part (2₁) comprising a conductive pattern of magnetic electrically conductive parts, **characterized in that** the holding part (2₂) and the elastic connector part (2₁) are integrally molded into one piece.

2. A holder as claimed in claim 2, **characterized in that** the elastic connector part (2₁) is comprised of a composition obtained by mixing 5 to 50 weight parts of magnetic electric conductor with 100 weight parts of liquid polymer.

3. A method for manufacturing a holder (2) as claimed in claim 1, comprising the steps of: pouring a liquid polymer mixed with a magnetic electric conductor into a metallic mold for forming a holder; applying a magnetic field to a desired position in the metallic mold; identifying the connector part by orienting the magnetic electric conductor by the magnetic field; and then, integrally molding the holding part and the elastic connector part into one piece by crosslinking the liquid polymer.

## Patentansprüche

1. Haltevorrichtung (2) für ein eingebautes elektronisches Teil (1), die ein Halteteil (2₂) mit einem elastischen Körper zur Aufnahme des eingebauten elektronischen Teils (1) und ein elastisches Verbindungsteil (2₁) mit einer leitfähigen Struktur aus magnetischen, elektrisch leitenden Teilen aufweist, **dadurch gekennzeichnet, daß** das Halteteil (2₂) und das elastische Verbindungsteil (2₁) integral zu einem Stück geformt sind.

2. Haltevorrichtung nach Anspruch 1, **dadurch gekennzeichnet, daß** das elastische Verbindungsteil (2₁) aus einer Zusammensetzung besteht, die man durch Vermischen von 5 bis 50 Gewichtsteilen eines magnetischen elektrischen Leiters mit 100 Gewichtsteilen flüssigem Polymer erhält.

3. Verfahren zur Herstellung einer Haltevorrichtung (2) gemäß Anspruch 1, mit den folgenden Schritten: Gießen eines flüssigen Polymers, das mit einem magnetischen elektrischen Leiter vermischt ist, in eine Metallform zum Formen einer Haltevorrichtung; Anlegen eines Magnetfeldes an eine gewünschte Position in der Metallform; Identifikation des Verbindungsteils durch Orientieren des magnetischen elektrischen Leiters durch das Magnetfeld; und anschließend Formen des Halteteils und des elastischen Verbindungsteils in einem Stück durch Vernetzen des flüssigen Polymers.

## Revendications

1. Support (2) pour un élément électronique intégré (1), comprenant une partie de support (2₂) comportant un corps élastique destiné à supporter l'élément électronique intégré (1) et une partie de connexion élastique (2₁) comprenant un motif conducteur d'éléments magnétiques conducteurs d'électricité, **caractérisé en ce que** la partie de support (2₂) et la partie de connexion élastique (2₁) sont moulées d'une seule pièce.

2. Support selon la revendication 1, **caractérisé en ce que** la partie de connexion élastique (2₁) est composée d'une composition produite en mélangeant 5 à 50 parties en poids d'un conducteur électrique magnétique avec 100 parties en poids d'un polymère liquide.

3. Procédé de fabrication d'un support (2) selon la revendication 1, comprenant les étapes ci-dessous: versement d'un polymère liquide mélangé avec un conducteur électrique magnétique dans un moule métallique pour former un support; application d'un champ magnétique à la position voulue dans le moule métallique; identification de la partie de connexion en orientant le conducteur électrique magnétique par le champ magnétique; et moulage d'une seule pièce de la partie de support et de la partie de connexion électrique par réticulation du polymère liquide.
